# EUROPEAN PATENT APPLICATION

(11) **EP 4 571 581 A1**
(43) Date of publication of application: **18.06.2025**
(21) Application number: 24217126.2
(22) Date of filing: 03.12.2024
(51) Int. Cl.: G06N 3/0464, G06N 3/063

(54) **WAFER CALCULATOR AND METHOD OF FABRICATING WAFER CALCULATOR**

(30) Priority: 15.12.2023 KR 20230183403
(71) Applicant: Samsung Electronics Co., Ltd., Suwon-si, Gyeonggi-do 16677 (KR)
(72) Inventor: Bae, Chisung, 16678 Suwon-si, Gyeonggi-do (KR); Kim, Laehoon, 16678 Suwon-si, Gyeonggi-do (KR); Kim, Sang Joon, 16678 Suwon-si, Gyeonggi-do (KR); Lee, Jongwoo, 16678 Suwon-si, Gyeonggi-do (KR)
(74) Representative: Grünecker Patent- und Rechtsanwälte PartG mbB

(57) **Abstract**

A wafer calculator and a method of fabricating the wafer calculator are provided. The wafer calculator includes: processing elements each having a respective dedicated semiconductor pattern that is configured to perform an operation of a respectively corresponding partial area among partial areas of an artificial intelligence (Al) model; and routing elements that are each configured to provide a communication path for exchanging operation results of the operations of the partial areas according to a network structure of the AI model.

## Description

### BACKGROUND

### 1. Field

The following description relates to a wafer calculator and a method of fabricating the wafer calculator.

### 2. Description of Related Art

An artificial intelligence (Al) model may perform inference suitable for a purpose by mapping input data to output data in a non-linear relationship after training the AI model based on machine learning. With the recent advancement of AI models, the size of AI models and the capacity of training data are gradually increasing. In addition, the cost of power for providing services using AI models is significantly increasing. Currently, AI models are mainly implemented using the von Neumann architecture. In the von Neumann architecture, a calculator and storage are separately disposed, and several devices share a bus. This architecture is not optimal for AI models that may need to operate on amounts of data too large for the shared bus to handle efficiently.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is what is claimed in the independent claims. Preferred embodiments are specified in the dependent claims.

In one general aspect, a wafer calculator includes: processing elements each having a respective dedicated semiconductor pattern that is configured to perform an operation of a respectively corresponding partial area among partial areas of an artificial intelligence (Al) model; and routing elements that are each configured to provide a communication path for exchanging operation results of the operations of the partial areas according to a network structure of the AI model.

The dedicated semiconductor patterns of the respective processing elements may each include a semiconductor device configured specifically for the operation of the respectively corresponding partial area, a reconfigurable semiconductor device configured specifically for the operation of the respectively corresponding partial area, or a combination thereof.

A first wafer may include the processing elements, a second wafer may include the routing elements, and the first wafer and the second wafer together may form a sandwich structure.

The processing elements may correspond to dies manufactured in a first size using a first wafer, and the routing elements may correspond to dies manufactured in a second size using a second wafer.

The first size may be different from the second size.

Each processing element may include: a memory block configured to store weights for the operation of the corresponding partial area; and a processing block configured to perform the operation of the corresponding partial area by applying the weights to the dedicated semiconductor pattern.

At least one memory block, among the memory blocks, may be configured to perform at least a portion of its operation of its corresponding partial area based on in-memory computing (IMC).

The communication path of the routing elements may be reconfigurable.

The processing elements may be arranged to form partial groups thereof, and wherein each routing element is arranged to at least partially overlap each of the processing elements in a corresponding partial group.

The routing elements may each be configured to connect, among the processing elements, at least a portion of corresponding processing elements belonging to the corresponding partial group to each other according to the structure of the AI model.

The processing elements may correspond to dies of a first wafer, the routing elements may correspond to dies of a second wafer, and the first wafer and the second wafer may have a stacked structure that forms the wafer calculator.

In another general aspect, an electronic device includes: a wafer calculator configured to implement an artificial intelligence (Al) model; and at least one processor configured to input input data to the wafer calculator, configured to receive output data generated by the implementation of the AI model according to the input of the input data, and configured to perform an additional operation based on the output data, wherein the wafer calculator includes: processing elements each having a respective dedicated semiconductor pattern that is configured to perform an operation of a respectively corresponding partial area among partial areas of the AI model; and routing elements that are each configured to provide a communication path for exchanging operation results of the operations of the partial areas according to a network structure of the AI model.

Each of the dedicated semiconductor patterns of the respective processing elements may include a semiconductor device configured specifically for the operations of the respectively corresponding partial area, a reconfigurable semiconductor device configured specifically for the operation of the respectively corresponding partial area, or a combination thereof.

The processing elements may correspond to dies manufactured in a first size using a first wafer, and the routing elements may correspond to dies manufactured in a second size using a second wafer.

Each processing element may include: a memory block configured to store weights for the operation of the corresponding partial area; and a processing block configured to perform the operation of the corresponding partial area by applying the weights to the dedicated semiconductor pattern.

The processing elements may correspond to dies of a first wafer, the routing elements may correspond to dies of a second wafer, and the wafer calculator may include the first wafer and the second wafer arranged in a stacked structure.

In another general aspect, a method of fabricating a wafer calculator includes: manufacturing processing elements each having a respective dedicated semiconductor pattern that is configured to perform an operation of a corresponding partial area among partial areas of an artificial intelligence (Al) model, using a first wafer; and manufacturing routing elements that are each configured to provide a communication path for exchanging operation results of the operations of the partial areas according to a network structure of the AI model, using a second wafer.

The dedicated semiconductor patterns of the respective processing elements may each include a semiconductor device configured specifically for the operation of the respectively corresponding partial area, a reconfigurable semiconductor device configured specifically for the operation of the respectively corresponding partial area, or a combination thereof.

The processing elements may correspond to dies manufactured in a first size using the first wafer, and the routing elements may correspond to dies manufactured in a second size using the second wafer.

The method may further include: stacking the second wafer on the first wafer or the first wafer on the second wafer.

Other features and aspects will be apparent from the following detailed description, the drawings, and the claims.

### BRIEF DESCRIPTION OF THE DRAWINGS

FIG. 1 illustrates an example of a relationship between an artificial intelligence (Al) model and a wafer calculator, according to one or more embodiments.
FIG. 2 illustrates an example of a configuration and stacked structure of each wafer, according to one or more embodiments.
FIGS. 3 to 5 illustrate examples of a configuration of processing elements, according to one or more embodiments.
FIG. 6 illustrates an example of a configuration of an electronic device including a wafer calculator, according to one or more embodiments.
FIG. 7 illustrates an example of a method of fabricating a wafer calculator, according to one or more embodiments.

Throughout the drawings and the detailed description, unless otherwise described or provided, the same or like drawing reference numerals will be understood to refer to the same or like elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As used herein, the term "and/or" includes any one and any combination of any two or more of the associated listed items. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

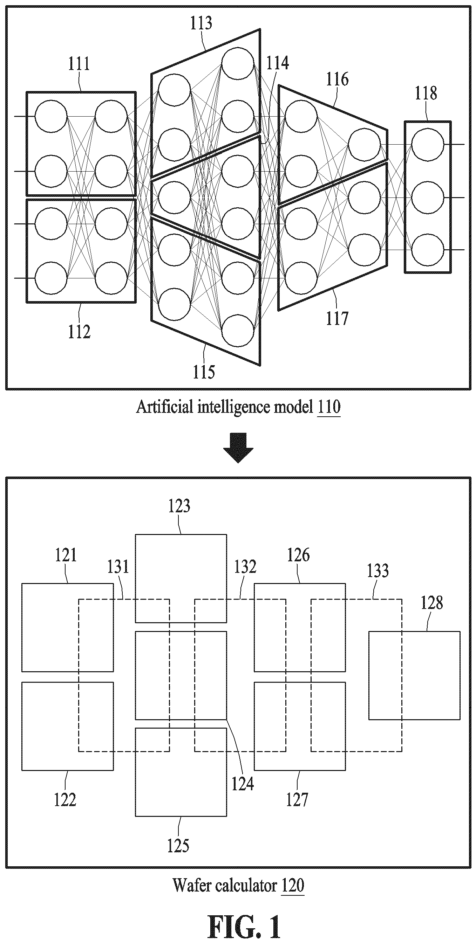

FIG. 1 illustrates an example of a relationship between an artificial intelligence (Al) model and a wafer calculator. Referring to FIG. 1, an AI model 110 may be implemented as a wafer calculator 120. Unlike the von Neumann architecture, the wafer calculator 120 may be implemented as a semiconductor structure analogous to a model (e.g., connectome) of a biological brain. The wafer calculator 120 may be implemented as a customized semiconductor structure for the AI model 110.

The AI model 110 may include first to eighth partial areas 111 to 118. In FIG. 1, a fully-connected neural network is shown as the AI model 110, but the AI model 110 may be a type of neural network other than the fully-connected neural network or may be based on a type of AI architecture other than a neural network.

The wafer calculator 120 may include first to eighth processing elements 121 to 128 and first to third routing elements 131 to 133. The wafer calculator 120 may include the first to eighth processing elements 121 to 128 corresponding to the first to eighth partial areas 111 to 118. For example, the AI model 110 may include a neural network, and the first to eighth partial areas 111 to 118 may be distinguished based on layers or subnetworks of the neural network. For example, one or more layers may be assigned to at least a portion of the first to eighth partial areas 111 to 118, and the one or more first to eighth partial areas 111 to 118 may be assigned to at least a portion of the one or more layers. In FIG. 1, a portion of a first layer and a portion of a second layer may be assigned to the first partial area 111, and the remaining portion of the first layer and the remaining portion of the second layer may be assigned to the second partial area 112. In other words, a layer may span multiple partial areas, and a partial layer may have more than one layer (any of which may be partial).

Depending on the type and/or structure of the AI model 110, an operation corresponding to each of the first to eighth partial areas 111 to 118 may be defined. For example, a weighted sum operation may be performed on a fully-connected neural network, and a convolution operation may be performed on a convolutional neural network (CNN). In FIG. 1, an operation of the first partial area 111 may be a weighted sum operation associated with a portion of the first layer (on the left) and a portion of the second layer.

Each of the first to eighth partial areas 111 to 118 and each of the first to eighth processing elements (PEs) 121 to 128 may form a corresponding area-PE pair. For example, the first partial area 111 and the first processing element 121 may form a first corresponding pair and the eighth partial area 118 and the eighth processing element 128 may form an eighth corresponding pair. A processing element (e.g., the first processing element 121) that forms a corresponding pair with a partial area (e.g., the first partial area 111) may be referred to as the corresponding processing element of the corresponding partial area. A partial area (e.g., the first partial area 111) that forms a corresponding pair with a processing element (e.g., the first processing element 121) may be referred to as the corresponding partial area of the corresponding processing element.

Each of the first to eighth processing elements 121 to 128 may have a dedicated semiconductor pattern that performs an operation of a corresponding partial area. The first to eighth processing elements 121 to 128 may have dedicated capabilities for corresponding partial areas instead of general-purpose operation capabilities. The dedicated semiconductor pattern (PE) of an area-PE pair may include a semiconductor device designed specifically for the operation of the corresponding partial area, reconfigurable semiconductor device configured specifically for the operation, or combination thereof. For example, in FIG. 1, the first processing element 121 may be/include a semiconductor device designed specifically for a weighted sum operation of the first partial area 111. In another example, the first processing element 121 may be/include a reconfigurable semiconductor device, and the reconfigurable semiconductor device of the first processing element 121 may be configured specifically for the weighted sum operation of the first partial area 111.

The first to eighth processing elements 121 to 128 may sequentially generate operation results corresponding to values of input data using the dedicated semiconductor pattern. The first to eighth processing elements 121 to 128 may process the values of input data in parallel in a pipeline manner. For example, when the first processing element 121 generates an operation result A1 based on input data A0, the third processing element 123 may generate an operation result A2 based on the operation result A1. The first processing element 121 may generate an operation result B1 based on input data B0 while the third processing element 123 generates the operation result A2. The pipeline-based parallel processing described above may further improve the speed of AI operations.

The wafer calculator 120 may include the first to third routing elements 131 to 133 to provide a communication path for exchanging operation results of the first to eighth partial areas 111 to 118 according to the structure of the AI model 110. The AI model 110 may have a structure optimized for operation purposes. For example, when the AI model 110 includes a neural network, layers and/or neurons of the neural network may have a constant connection structure. For example, in the case of a fully-connected neural network, full connectivity may be formed between neurons in neighboring layers. In this case, the operation result of a neuron in a layer may need to be transmitted to all neurons in the next layer. In another example, in the case of a CNN, a sequential connection may be formed between neighboring layers. In this case, the operation result of a layer may need to be transmitted to the next layer.

The first to third routing elements 131 to 133 may provide the communication path for exchanging operation results of the first to eighth partial areas 111 to 118 according to the structure of the AI model 110. For example, as shown in FIG. 1, when the AI model 110 is a fully-connected neural network, the first routing element 131 may provide (i) a communication path through which the operation result of the first partial area 111 (a result corresponding to an output of some neurons of the second layer of the AI model 110) may be transmitted to the third, four, and fifth partial areas 113-115 and (ii) a communication path through which the operation result of the second partial area 112 (a result corresponding to an output of some other neurons of the second layer of the AI model 110) may be transmitted to the third, fourth, and fifth partial areas 113-115.

The communication path(s) of the first to third routing elements 131 to 133 may be reconfigurable. The first to third routing elements 131 to 133 may include routing segments and switches that selectively connect the routing segments to each other. The routing segments may provide a partial path, and the switches may selectively connect the routing segments to each other and may form a communication path. The first to third routing elements 131 to 133 may provide a reconfigurable communication path through the routing segments and the switches. The switches may selectively connect the routing segments to each other based on the structure of the AI model 110. For example, a routing matrix corresponding to the structure/architecture of the AI model 110 may be determined, and the switches may be controlled/configured to connect the routing segments to each other according to the routing matrix. As a result, communication paths corresponding to the structure of the AI model 110 may be provided.

The first to eighth processing elements 121 to 128 may form a direct connection or an indirect connection based on the first to third routing elements 131 to 133. A connection through a single routing element may be referred to as a direct connection, and a connection through multiple routing elements may be referred to as an indirect connection. A connection between the first processing element 121 and the third processing element 123 through a single routing element of the first routing element 131 may correspond to a direct connection, and a connection between the first processing element 121 and the sixth processing element 126 through multiple routing elements of the first routing element 131 and the second routing element 132 may correspond to an indirect connection.

Partial groups of the first to eighth processing elements 121 to 128 may be determined based on direct connections formed by the first to third routing elements 131 to 133. For example, the first processing element 121 to the fifth processing element 125 that each form a direct connection through the first routing element 131 may form a first partial group, the third processing element 121 to the seventh processing element 127 that each form a direct connection through the second routing element 132 may form a second partial group, and the sixth processing element 126 to the eighth processing element 128 that each form a direct connection through the third routing element 133 may form a third partial group.

The partial groups of the first to eighth processing elements 121 to 128 may form corresponding pairs with the first to third routing elements 131 to 133 based on the direct connections formed by the first to third routing elements 131 to 133. For example, the first partial group of the first to eighth processing elements 121 to 128 may form a corresponding pair with the first routing element 131, the second partial group of the first to eighth processing elements 121 to 128 may form a corresponding pair with the second routing element 132, and the third partial group of the first to eighth processing elements 121 to 128 may form a corresponding pair with the third routing element 133. A routing element (e.g., the first routing element 131) that forms a corresponding pair with a partial group (e.g., the first partial group) may be referred to as a corresponding routing element of a corresponding partial group. A partial group (e.g., the first partial group) that forms a corresponding pair with a routing element (e.g., the first routing element 131) may be referred to as a corresponding partial group of a corresponding routing element. In short, partial groups may be formed via respective routing elements.

Each of the first to third routing elements 131 to 133 may be disposed to overlap at least some area of the corresponding partial group of the partial groups of the first to eighth processing elements 121 to 128. Each of the first to third routing elements 131 to 133 may be disposed to overlap some areas of each processing element belonging to the corresponding partial group. For example, the first routing element 131 may be disposed to overlap at least some area of the first partial group. Specifically, the first routing element 131 may be disposed to overlap some area of each of the first to fifth processing elements 121 to 125 belonging to the first partial group. The first to third routing elements 131 to 133 may be set to connect, among the first to eighth processing elements 121 to 128, at least a portion of corresponding processing elements belonging to the corresponding partial group to each other according to the structure of the AI model 110.

A physical connection between any of the first to eighth processing elements 121 to 128 and any of the first to third routing elements 131 to 133 may be formed through an overlapping area. For example, the processing elements 121 to 128 and the first to third routing elements 131 to 133 may directly contact each other or may be indirectly connected to each other through a filler, pillar, ball, pump, or combination thereof. The filler, pillar, ball, and pump are examples. However, the examples are not limited thereto.

The first to eighth processing elements 121 to 128 may correspond to (e.g., may each be) dies manufactured in a first size using a first wafer, and the first to third routing elements 131 to 133 may correspond to (or be) dies manufactured in a second size using a second wafer. The first wafer may be different from the second wafer. The first size may be different from the second size. For example, the second size may be greater than the first size but is not limited thereto. The first to eighth processing elements 121 to 128 may be generated by a photolithography process using a mask or reticle in the first size. The mask or reticle in the first size may have a dedicated semiconductor pattern that performs the operation on the corresponding partial area of the AI model 110. The first to third routing elements 131 to 133 may be generated by a photolithography process using a mask or reticle in the second size. The mask or reticle in the second size may have the semiconductor pattern corresponding to the routing segments and the switches. The switches may selectively connect the routing segments to each other according to the structure of the AI model 110 and may provide the communication path for the corresponding partial group.

Even when the AI model 110 is a large-scale model, the wafer calculator 120 may imitate the AI model 110 through the first to eighth processing elements 121 to 128 and the first to third routing elements 131 to 133. Since the wafer calculator 120 does not require the movement of weights, unnecessary waste of power due to data movement may be prevented. In addition, since the AI model 110 itself is implemented as the wafer calculator 120, there may be no additional energy consumption to analyze the AI model 110. Additionally, parallel operations by as many layers of the AI model 110 may be performed through pipeline processing. The parallel operations may further improve the operation speed.

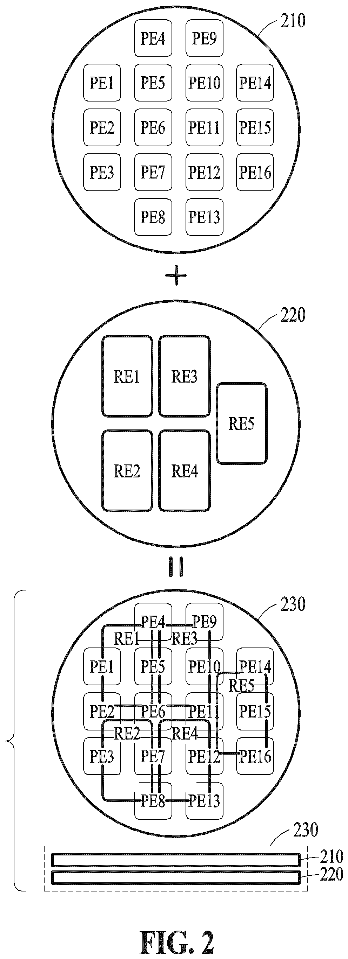

FIG. 2 illustrates an example configuration of a stacked wafer structure, according to one or more embodiments. Referring to FIG. 2, processing elements PE1 to PE16 may be manufactured using a first wafer 210 and routing elements RE1 to RE5 may be manufactured using a second wafer 220. The processing elements PE1 to PE16 may correspond to dies of the first wafer 210, and the routing elements RE1 to RE5 may correspond to dies of the second wafer 220. The routing elements RE1 to RE5 may each be larger than each of the processing elements PE1 to PE16 but are not limited thereto.

The first wafer 210 and the second wafer 220 may form a stacked structure. For example, the stacked structure may be formed by stacking the second wafer 220 on the first wafer 210 or the first wafer 210 on the second wafer 220. A wafer calculator 230 may include the first wafer 210 and the second wafer 220. Although FIG. 2 illustrates an example in which the first wafer 210 is stacked on the second wafer 220, the second wafer 220 may instead be stacked on the first wafer 210. The first wafer 210 and the second wafer 220 may be directly connected to each other or may be indirectly connected to each other through a filler, pillar, ball, pump, or combination thereof. The filler, pillar, ball, and pump are non-limiting examples. The first wafer 210 and the second wafer 220 may be entirely packaged at a wafer level scale so that the wafer calculator 230 may be manufactured. That is to say, in some examples, each wafer may be a wafer with fully formed elements (PEs or REs, as the case may be) and still be in the wafer format.

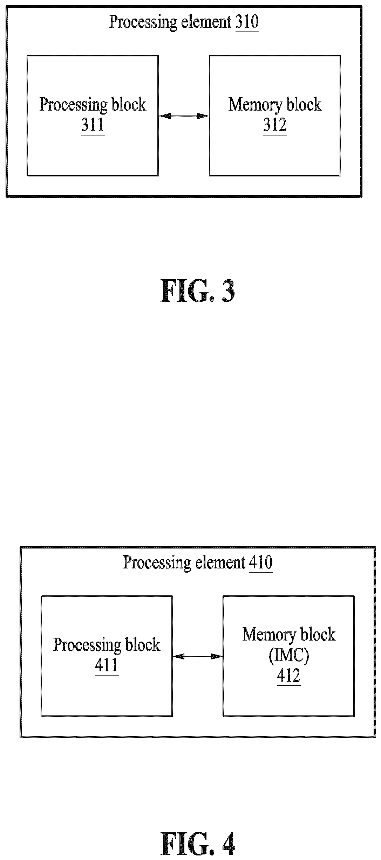

FIGS. 3 to 5 illustrate examples of a configuration of processing elements, according to one or more embodiments. Referring to FIG. 3, a processing element 310 may include a processing block 311 and a memory block 312. The processing block 311 and the memory block 312 may be formed on a die corresponding to a processing element 410. The memory block 312 may store weights (e.g., network weights) for an operation on a corresponding partial area. The weights may be parameters of an AI model (e.g., a neural network). The memory block 312 may store weights of the AI model that have been loaded into the memory block 312. When the weights of the AI model are updated, the updated weights may be newly loaded into the memory block 312. The processing block 311 may apply the weights to a dedicated semiconductor pattern thereof to perform the operation on the corresponding partial area. The processing block 311 may perform an operation based on input data and the weights. For example, the input data may be data that is input to a wafer calculator or may be data that is output from the previous layer.

Referring to FIG. 4, the processing element 410 may include a processing block 411 and a memory block 412. The memory block 412 may store weights for an operation on a corresponding partial area. The memory block 412 may perform both storage and operation functions. The memory block 412 may perform at least a portion of the operation on the corresponding partial area based on in-memory computing (IMC). That is, the memory block 412 may be configured to persistently store data and also perform operations on that data as it is stored before, during, and after the operations (the stored data may be treated as on operand and input data may serve as another operand for an operation therebetween).

The memory block 412 may include a memory cell array. The memory cell array may function to store data as a memory device and may also function as an operation device to derive an operation result according to the stored data. The memory cell array may perform an operation (e.g., a multiply-accumulate (MAC) operation) through IMC. IMC is a class of technology that uses a structural characteristic and operating method of a memory element and derives an operation result between data stored in the memory element and an input (e.g., a control signal) to the memory element.

IMC is a computer architecture that performs a direct operation inside a memory in which data is stored, may reduce data movement between the operation device and the memory device, and may increase power efficiency. That is to say, an IMC device may function, at the same time, as both a memory for storing data (regardless of whether it is processed or not) and a processor for processing the stored data, which such is needed. In a state in which one of either weight data or input feature data is stored in the memory cell array (as a first operand), when the other one is input to the memory cell array (as a second operand), a MAC operation result between the operands may be derived by, and output from, the memory cell array. The input feature data may be simply referred to as input data. Accordingly, data transmission may be minimized during an operation process.

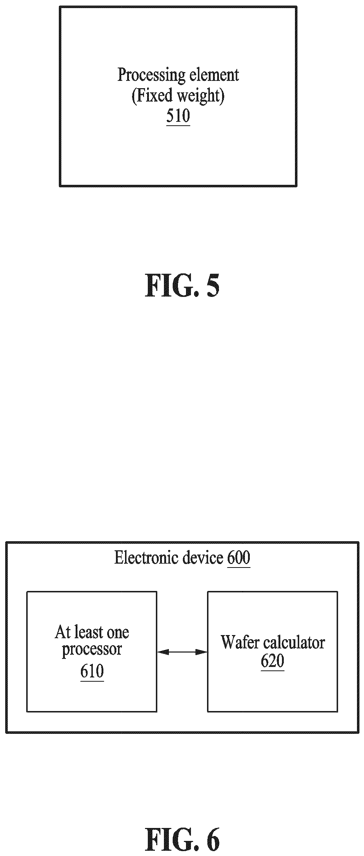

Referring to FIG. 5, a processing element 510 may have a fixed (hardwired) weight. The processing function and memory function of the processing element 510 may be implemented as a fixed physical structure such as logic. Processing elements of a wafer calculator including the processing element 510 may perform an operation on an AI model using fixed weights.

FIG. 6 illustrates an example configuration of an electronic device including a wafer calculator, according to one or more embodiments. Referring to FIG. 6, an electronic device 600 may include at least one processor 610 and a wafer calculator 620. Although not shown in FIG. 6, the electronic device 600 may further include other components such as a memory, sensor (e.g., camera), storage device, input device, output device, and network interface. For example, the electronic device 600 may be implemented as at least part of a mobile device such as a mobile phone, smartphone, personal digital assistant (PDA), netbook, tablet computer, or laptop computer, a wearable device such as a smart watch, smart band, or smart glasses, a computing device such as a desktop or server, a home appliance such as a television, smart television, or refrigerator, a security device such as a door lock, or a vehicle such as an autonomous vehicle or smart vehicle.

The wafer calculator 620 may implement an AI model. The wafer calculator 620 may include (i) processing elements each having a dedicated semiconductor pattern that performs an operation on a corresponding partial area of partial areas of the AI model and (ii) routing elements that provide a communication path for exchanging operation results of the partial areas according to a structure of the AI model.

The at least one processor 610 may execute functions and instructions to be executed by the electronic device 600. For example, the at least one processor 610 may execute instructions stored in the memory and/or storage device. The at least one processor 610 may input input data to the wafer calculator 620, receive output data generated by the AI model according to an input of the input data, and perform an additional operation based on the output data. For example, the input data may include audio data, image data, sensor data, or a combination thereof, and the output data may include, for example, a recognition result based on the input data, or other forms of inference output. The additional operation is an operation according to the recognition/inference result and may include, for example, an operation for outputting (e.g., displaying) the recognition/inference result, an operation for transmitting the recognition result to another device, an operation for further processing the recognition/inference result, etc.

The at least one processor 610 may include a pre-processing module and a post-processing module. The pre-processing module may input the input data to the wafer calculator 620, and the post-processing module may perform the additional operation based on the output data. The pre-processing module and the post-processing module may correspond to a hardware module.

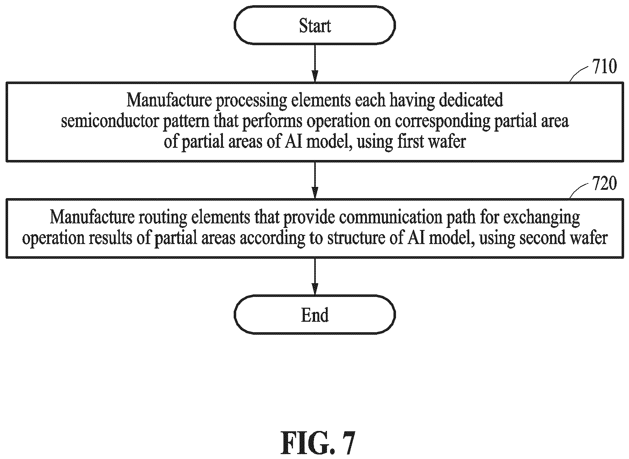

FIG. 7 illustrates an example method of fabricating a wafer calculator, according to one or more embodiments. Referring to FIG. 7, in operation 710, a fabricating apparatus may manufacture processing elements each having a dedicated semiconductor pattern that performs an operation of a corresponding partial area of partial areas of an AI model, using a first wafer, and in operation 720, the fabricating apparatus may manufacture, using a second wafer, routing elements that provide a communication path for exchanging operation results of the partial areas according to a structure of the AI model.

The dedicated semiconductor pattern may include a semiconductor device designed specifically for the operation of the corresponding partial area, a reconfigurable semiconductor device configured specifically for the operation, or a combination thereof. The processing elements may correspond to respective dies manufactured in a first size using the first wafer, and the routing elements may correspond to dies manufactured in a second size using the second wafer. The fabricating apparatus may stack the second wafer on the first wafer or the first wafer on the second wafer.

The computing apparatuses, the electronic devices, the processors, the memories, the displays, the information output system and hardware, the storage devices, and other apparatuses, devices, units, modules, and components described herein with respect to FIGS. 1-7 are implemented by or representative of hardware components. Examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-7 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above disclosure, the scope of the disclosure may also be defined by the claims.

## Claims

1. A wafer calculator comprising:
processing elements each having a respective dedicated semiconductor pattern that is configured to perform an operation of a respectively corresponding partial area among partial areas of an artificial intelligence, AI, model; and
routing elements that are each configured to provide a communication path for exchanging operation results of the operations of the partial areas according to a network structure of the AI model.

2. The wafer calculator of claim 1, wherein the dedicated semiconductor patterns of the respective processing elements each comprise a semiconductor device configured specifically for the operation of the respectively corresponding partial area, a reconfigurable semiconductor device configured specifically for the operation of the respectively corresponding partial area, or a combination thereof.

3. The wafer calculator of claim 1 or 2, wherein a first wafer comprises the processing elements, a second wafer comprises the routing elements, and the first wafer and the second wafer together form a sandwich structure.

4. The wafer calculator of one of claims 1 to 3, wherein
the processing elements correspond to dies manufactured in a first size using a first wafer, and
the routing elements correspond to dies manufactured in a second size using a second wafer.

5. The wafer calculator of claim 4, wherein the first size is different from the second size.

6. The wafer calculator of one of claims 1 to 5, wherein each processing element comprises:
a memory block configured to store weights for the operation of the corresponding partial area; and
a processing block configured to perform the operation of the corresponding partial area by applying the weights to the dedicated semiconductor pattern.

7. The wafer calculator of claim 6, wherein at least one memory block, among the memory blocks, is configured to perform at least a portion of its operation of its corresponding partial area based on in-memory computing, IMC.

8. The wafer calculator of one of claims 1 to 7, wherein the communication path of the routing elements is reconfigurable.

9. The wafer calculator of one of claims 1 to 8, wherein the processing elements are arranged to form partial groups thereof, and wherein each routing element is arranged to at least partially overlap each of the processing elements in a corresponding partial group.

10. The wafer calculator of claim 9, wherein the routing elements each are configured to connect, among the processing elements, at least a portion of corresponding processing elements belonging to the corresponding partial group to each other according to the structure of the AI model.

11. The wafer calculator of one of claims 1 to 10, wherein
the processing elements correspond to dies of a first wafer,
the routing elements correspond to dies of a second wafer, and
the first wafer and the second wafer have a stacked structure that forms the wafer calculator.

12. An electronic device comprising:
a wafer calculator of one of claims 1 to 11 configured to implement an artificial intelligence, AI, model; and
at least one processor configured to input input data to the wafer calculator, configured to receive output data generated by the implementation of the AI model according to the input of the input data, and configured to perform an additional operation based on the output data.

13. A method of fabricating a wafer calculator, the method comprising:
manufacturing processing elements each having a respective dedicated semiconductor pattern that is configured to perform an operation of a corresponding partial area among partial areas of an artificial intelligence, AI, model, using a first wafer; and
manufacturing routing elements that are each configured to provide a communication path for exchanging operation results of the partial areas according to a network structure of the AI model, using a second wafer.

14. The method of claim 13, wherein the dedicated semiconductor patterns of the respective processing elements each comprise a semiconductor device configured specifically for the operation of the respectively corresponding partial area, a reconfigurable semiconductor device configured specifically for the operation of the respectively corresponding partial area, or a combination thereof.

15. The method of claim 13 or 14, further comprising:
stacking the second wafer on the first wafer or the first wafer on the second wafer.
